# EUROPEAN PATENT APPLICATION

(11) **EP 4 411 020 A1**
(43) Date of publication of application: **07.08.2024**
(21) Application number: 24155474.0
(22) Date of filing: 02.02.2024
(51) Int. Cl.: C23C 16/04, C23C 16/34, C23C 16/455

(54) **METHOD OF PROCESSING SUBSTRATE, METHOD OF MANUFACTURING SEMICONDUCTOR DEVICE, PROGRAM, AND SUBSTRATE PROCESSING APPARATUS**

(30) Priority: 03.02.2023 JP 2023014958
(71) Applicant: Kokusai Electric Corp., Tokyo 1010045 (JP)
(72) Inventor: SUYAMA, Nagisa, Toyama, 9392393 (JP); KOIDE, Hiroyuki, Toyama, 9392393 (JP); NAGAHASHI, Tomoya, Toyama, 9392393 (JP)
(74) Representative: Bardehle Pagenberg Partnerschaft mbB Patentanwälte Rechtsanwälte

(57) **Abstract**

There is provided a technique that includes: (a) supplying a first process gas to the substrate; and (b) supplying a second process gas from a second reservoir to the substrate, wherein (b) is performed in a manner so as to shorten a time until a successive reaction of the second process gas on the substrate converges.

## Description

### CROSS-REFERENCE TO RELATED APPLICATION

This application is based upon and claims the benefit of priority from Japanese Patent Application No. 2023-014958, filed on February 3, 2023, the entire contents of which are incorporated herein by reference.

### TECHNICAL FIELD

The present disclosure relates to a method of processing a substrate, a method of manufacturing a semiconductor device, a program, and a substrate processing apparatus.

### BACKGROUND

In the related art, as a process of manufacturing a semiconductor device, there is a technique of supplying a precursor gas and/or reaction gas at each supply time according to in-plane concentration distribution of by-products formed on a substrate.

However, uniformity of a film formed on the substrate may not meet uniformity demanded for semiconductor device performance.

### SUMMARY

Some embodiments of the present disclosure provide a technique capable of improving uniformity of a film formed over a substrate.

According to some embodiments of the present disclosure, there is provided a technique that includes: (a) supplying a first process gas to the substrate; and (b) supplying a second process gas from a second reservoir to the substrate, wherein (b) is performed in a manner so as to shorten a time until a successive reaction of the second process gas on the substrate converges.

### BRIEF DESCRIPTION OF DRAWINGS

The accompanying drawings, which are incorporated in and constitute a part of the specification, illustrate embodiments of the present disclosure.
FIG. 1 is a longitudinal cross-sectional view schematically illustrating a substrate processing apparatus according to embodiments of the present disclosure.
FIG. 2A is a diagram illustrating a first gas supply system according to embodiments of the present disclosure, FIG. 2B is a diagram illustrating a second gas supply system according to embodiments of the present disclosure, and FIG. 2C is a diagram illustrating a third gas supply system according to embodiments of the present disclosure.
FIG. 3A is a diagram illustrating a process chamber exhaust system according to embodiments of the present disclosure, and FIG. 3B is a diagram illustrating a transfer chamber exhaust system according to embodiments of the present disclosure.
FIG. 4 is a schematic configuration diagram of a controller in a substrate processing apparatus according to embodiments of the present disclosure, illustrating a control system of the controller in a block diagram.
FIG. 5 is a diagram illustrating a substrate-processing flow according to embodiments of the present disclosure.
FIG. 6 is a diagram illustrating a substrate-processing sequence according to embodiments of the present disclosure.

### DETAILED DESCRIPTION

Reference will now be made in detail to various embodiments, examples of which are illustrated in the accompanying drawings. In the following detailed description, numerous specific details are set forth to provide a thorough understanding of the present disclosure. However, it will be apparent to one of ordinary skill in the art that the present disclosure may be practiced without these specific details. In other instances, well-known methods, procedures, systems, and components are not described in detail so as not to obscure aspects of the various embodiments.

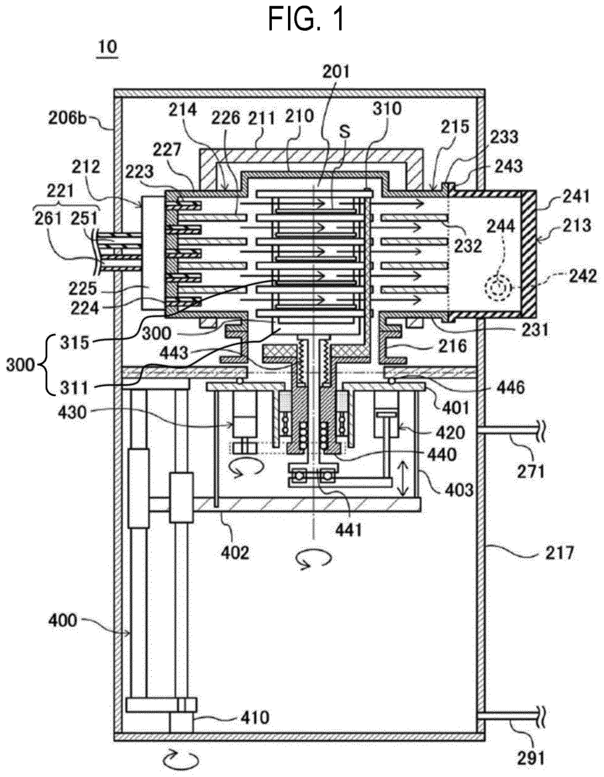

Hereinafter, some embodiments of the present disclosure will be described mainly with reference to FIGS. 1 to 6. In addition, the drawings used in the following description are schematic, and dimensional relationships, ratios, and the like of the respective components shown in the drawings may not match actual ones. Further, dimensional relationships, ratios, and the like of the respective components among plural drawings may not match one another.

### (1) Configuration of Substrate Processing Apparatus

A configuration of a substrate processing apparatus 10 will be described with reference to FIG. 1.

The substrate processing apparatus 10 includes a reaction tube storage chamber 206b, and includes, inside the reaction tube storage chamber 206b, a cylindrical reaction tube 210 extending in the vertical direction, a heater 211 serving as a heating part (furnace body) provided around the outer periphery of the reaction tube 210, a gas supply structure 212 serving as a gas supplier, and a gas exhaust structure 213 serving as a gas exhauster. The gas supplier may include an upstream gas guide 214 and nozzles 223 and 224 as described later. Further, the gas exhauster may include a downstream gas guide 215 as described later. A compartment of the reaction tube 210 in which a substrate S is processed is referred to as a process chamber 201. Further, the process chamber 201 may also be referred to as a process space inside which the substrate S is arranged.

The gas supply structure 212 is provided at an upstream side of the reaction tube 210 in a gas flow direction, and a gas is supplied from the gas supply structure 212 into the reaction tube 210. The gas is supplied to the substrate S in the horizontal direction. The gas exhaust structure 213 is provided at a downstream side of the reaction tube 210 in the gas flow direction, and the gas inside the reaction tube 210 is discharged from the gas exhaust structure 213. The gas supply structure 212, an interior of the reaction tube 210, and the gas exhaust structure 213 are in fluid communication with one another in the horizontal direction.

The upstream gas guide 214 is provided at an upstream side of the reaction tube 210 between the reaction tube 210 and the gas supply structure 212 to regulate a flow of the gas supplied from the gas supply structure 212. Further, the downstream gas guide 215 is provided at a downstream side of the reaction tube 210 between the reaction tube 210 and the gas exhaust structure 213 to regulate a flow of the gas discharged from the reaction tube 210. A lower end of the reaction tube 210 is supported by a manifold 216.

The reaction tube 210, upstream gas guide 214, and downstream gas guide 215 are formed in a continuous structure and are made of materials such as quartz or SiC, for example. These are formed as heat-permeable members that transmit heat radiated from the heater 211. The heat from the heater 211 heats the substrate S or the gas.

The gas supply structure 212 includes a distributor 225, which is connected to a gas supply pipe 251 and a gas supply pipe 261 and configured to distribute a gas supplied from each gas supply pipe. A plurality of nozzles 223 and 224 are provided at a downstream side of the distributor 225. The gas supply pipe 251 and the gas supply pipe 261 supply different types of gases as described later. The nozzles 223 and 224 are arranged in a vertical relationship or in a lateral relationship. In the embodiments of the present disclosure, the gas supply pipe 251 and the gas supply pipe 261 are also collectively referred to as a gas supply pipe 221. Each nozzle is also referred to as a gas discharger. The distributor 225 is configured to allow each gas to be supplied from the gas supply pipe 251 to the nozzle 223 and from the gas supply pipe 261 to the nozzle 224.

The upstream gas guide 214 includes a housing 227 and a partition plate 226. The partition plate 226 extends in the horizontal direction and is formed in a continuous structure without holes. Herein, the term "horizontal direction" refers to a sidewall direction of the housing 227, or a direction parallel to a surface of the substrate S inside the reaction tube 210. A plurality of partition plates 226 are arranged in the vertical direction. The partition plates 226 are fixed to a sidewall of the housing 227 and are configured to prevent the gas from moving beyond the partition plate 226 to a downward or upward adjacent region.

Each partition plate 226 is provided at a position corresponding to each substrate S. The nozzles 223 and 224 are provided between the partition plates 226 and between the partition plates 226 and the housing 227. A gas flow of the gas discharged from the nozzles 223 and 224 is regulated by the partition plates 226 and is then supplied to the surface of the substrate S. In other words, the gas is supplied from a lateral side of the substrate S when viewed from the substrate S.

In a state where the substrate S is supported by a substrate support 300 as described later, the downstream gas guide 215 is configured to include a ceiling higher than the uppermost substrate S and to include a bottom lower than the lowermost substrate S on the substrate support 300.

The downstream gas guide 215 includes a housing 231 and a partition plate 232. The partition plate 232 extends in the horizontal direction and is formed in a continuous structure without holes. Here, the term "horizontal direction" is the same as the above-described horizontal direction. Furthermore, a plurality of partition plates 232 are arranged in the vertical direction. The partition plates 232 are fixed to a sidewall of the housing 231 and are configured to prevent the gas from moving beyond the partition plates 232 to a downward or upward adjacent region. A flange 233 is provided at the side of the housing 231 that comes into contact with the gas exhaust structure 213.

Each partition plate 232 is positioned to correspond to the substrate S and to correspond to the partition plate 226. The corresponding partition plates 226 and 232 may provide at an equal height. Furthermore, when processing the substrate S, a height of the substrate S may be aligned with heights of the partition plates 226 and 232.

By providing the partition plates 226 and 232 in the above-described positional relationship, pressure loss may be made uniform at upstream and downstream sides of each substrate S in the vertical direction. In other words, a horizontal gas flow, as indicated by the arrows in the drawing, may be reliably formed with a suppressed vertical flow across the partition plate 226, the substrate S, and the partition plate 232. Accordingly, it is possible to reduce a difference in gas pressure on each substrate S. This enables uniform processing for each substrate S.

The gas exhaust structure 213 is provided at a downstream side of the downstream gas guide 215. The gas exhaust structure 213 mainly includes a housing 241 and an exhaust pipe connector 242. A flange 243 is provided at the housing 241 on the side of the downstream gas guide 215. The housing 231 and the housing 241 are formed in a structure with continuous heights at ceilings and bottoms thereof. An exhaust hole 244 is formed at the downstream of the housing 241 in the downward direction or horizontal direction to discharge the gas which passed through the downstream gas guide 215. The gas exhaust structure 213 is a lateral exhaust structure installed in the lateral direction of the reaction tube 210 to discharge the gas in the lateral direction of the substrate S.

A transfer chamber 217 is provided below the reaction tube 210 via the manifold 216. At the transfer chamber 217, the substrate S is placed (mounted) on the substrate support (hereinafter, sometimes simply referred to as "boat") 300 by a vacuum transfer robot via a substrate loading port, and the substrate S is discharged from the substrate support 300 by the vacuum transfer robot.

The substrate support 300, a partition plate support 310, and a vertical driver 400 configured to drive the substrate support 300 and partition plate support 310 (collectively referred to as "substrate holder") in both the vertical direction and the rotational direction may be stored in the transfer chamber 217. FIG. 1 illustrates a state where the substrate support 300 is raised by the vertical driver 400 and is stored in the reaction tube 210.

The vertical driver 400 includes a rotation driver 430 configured to rotate the substrate support 300 and the partition plate support 310 together and a boat up/down mechanism 420 configured to drive the substrate support 300 vertically relative to the partition plate support 310. The rotation driver 430 and the boat up/down mechanism 420 are fixed to a base flange 401, which serves as a lid supported on a base plate 402 by a side plate 403. A vacuum sealing O-ring 446 is installed on an upper surface of the base flange 401, and as illustrated in FIG. 1, is driven by a vertical drive motor 410 to be raised to a position where the upper surface of the base flange 401 is pressed against the transfer chamber 217, thereby maintaining the interior of the reaction tube 210 airtight. A vacuum bellows 443 is connected between a support piece 440 fixed to the partition plate support 310 and a support piece 441 fixed to the substrate support 300.

Next, details of the substrate support will be described with reference to FIG. 1.

The substrate support is formed as the substrate support 300 configured to support at least the substrate S, and is stored inside the reaction tube 210. The substrate S is arranged immediately below an inner wall of a ceiling plate of the reaction tube 210. Further, the substrate support is configured to move the substrate S by the vacuum transfer robot via the substrate loading port (not illustrated) in the transfer chamber 217, or transfers the moved substrate S to the interior of the reaction tube 210 for formation of a thin film over the surface of the substrate S. The substrate loading port is provided, for example, at a sidewall of the transfer chamber 217. In addition, the substrate support may include the partition plate support 310.

A plurality of substrates S are placed on the substrate support 300 at a predetermined interval in the vertical direction by a plurality of support rods 315 supported on a base 311. The space between the substrates S supported by the support rods 315 is partitioned by disc-shaped partition plates 314 fixed (supported) at a predetermined interval to a pillar 313 supported by the partition plate support 310. Here, the partition plates 314 are located immediately below the substrates S and located either above or below the substrates S or above and below the substrates S. The partition plate 314 obstruct the space between the respective substrates S. The predetermined interval between the substrates S placed on the substrate support 300 is the same as the vertical interval between the partition plates 314 fixed to the partition plate support 310. Further, a diameter of the partition plate 314 is larger than a diameter of the substrate S.

The base 311, the partition plates 314, and the plurality of support rods 315 are made of materials such as quartz or SiC, for example. In addition, although an example of supporting five substrates S on the substrate support 300 is illustrated here, but the present disclosure is not limited thereto. For example, the substrate support 300 may be configured to be capable of supporting approximately 5 to 50 substrates S. In addition, the partition plate 314 is also referred to as a separator.

In addition, notation of a numerical range such as "5 to 50" herein implies that a lower limit value and an upper limit value are included in that range. Thus, for example, "5 to 50 sheets" implies "5 sheets or more and 50 sheets or less." The same is applied to other numerical ranges.

In a step of forming a thin film over the substrate S, the partition plate 314 may be positioned at a height corresponding to the partition plate 226 and/or the partition plate 232. Specifically, heights of the partition plates 314, 226 and 232 may be aligned.

By using such a substrate support, it becomes easier to form a horizontal gas flow with a suppressed vertical flow across the partition plate 226, the substrate S, and the partition plate 232. Since this results in a uniform difference in gas pressure on each substrate S, it is possible to perform a uniform processing on the respective substrates S.

The partition plate support 310 and the substrate support 300 are driven by the vertical driver 400 in the vertical direction between the reaction tube 210 and the transfer chamber 217 and in the rotational direction around the center of the substrate S supported by the substrate support 300.

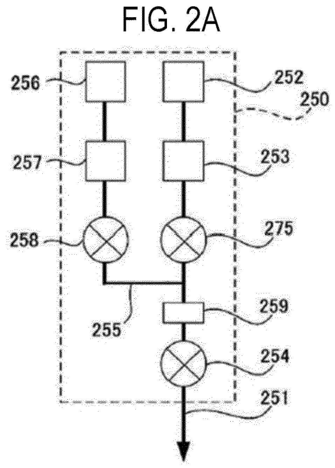

Next, details of a gas supply system will be described with reference to FIGS. 2A to 2C. As illustrated in FIG. 2A, at the gas supply pipe 251, a first gas source 252, a mass flow controller (MFC) 253 serving as a flow rate controller (flow rate control part), a valve 275 serving as an on/off valve, a tank 259 serving as a first reservoir configured to store a first process gas, and a valve 254 serving as an on/off valve are installed sequentially from the upstream side.

The first gas source 252 is a source of a first gas containing a first element (also referred to as "first element-containing gas"). The first gas is a precursor gas, i.e., a process gas.

A first gas supply system 250 (also referred to as "precursor gas supply system" or "process gas supply system") mainly includes the gas supply pipe 251, MFC 253, valve 275, tank 259, and valve 254. The first gas source 252 may also be included in the first gas supply system 250.

A gas supply pipe 255 is connected to the gas supply pipe 251 between the valve 275 and the tank 259. At the gas supply pipe 255, an inert gas source 256, a MFC 257, and a valve 258 serving as an on/off valve are installed sequentially from the upstream side. An inert gas is supplied from the inert gas source 256.

A first inert gas supply system mainly includes the gas supply pipe 255, MFC 257, and valve 258. The inert gas supplied from the inert gas source 256 acts as a purge gas that purges a gas remaining in the reaction tube 210 in a substrate-processing step. The inert gas source 256 may also be included in the first inert gas supply system. The first inert gas supply system may be included in the first gas supply system 250.

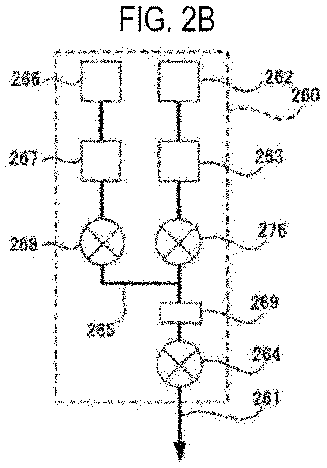

As illustrated in FIG. 2B, at the gas supply pipe 261, a second gas source 262, a MFC 263, a valve 276, a tank 269 serving as a second reservoir configured to store a second process gas, and a valve 264 are installed sequentially from the upstream side.

The second gas source 262 is a source of a second gas containing a second element (also referred to as "second element-containing gas"). The second gas is different from the first gas and may be a process gas. In addition, the second gas may be a reaction gas that reacts with a precursor of the first gas, which is the precursor gas, or as a modifying gas that modifies the surface of the substrate S.

A second gas supply system 260 (also referred to as "reaction gas supply system" or "process gas supply system") mainly includes the gas supply pipe 261, MFC 263, valve 276, tank 269, and valve 264. The second gas source 262 may also be included in the second gas supply system 260. In addition, FIG. 2B illustrates one second gas supply system 260, but the present disclosure is not limited thereto. A plurality of second gas supply systems 260 may be configured to be connectable in parallel.

A gas supply pipe 265 is connected to the gas supply pipe 261 between the valve 276 and the tank 269. At the gas supply pipe 265, an inert gas source 266, a MFC 267, and a valve 268 serving as an on/off valve are installed sequentially from the upstream side. An inert gas is supplied from the inert gas source 266.

A second inert gas supply system mainly includes the gas supply pipe 265, MFC 267, and valve 268. The inert gas supplied from the inert gas source 266 acts as a purge gas that purges a gas remaining in the reaction tube 210 in the substrate-processing step. The inert gas source 266 may also be included in the second inert gas supply system. The second inert gas supply system may be included in the second gas supply system 260.

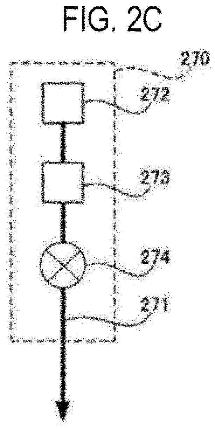

As illustrated in FIG. 2C, at a gas supply pipe 271, a third gas source 272, a MFC 273, and a valve 274 are installed sequentially from the upstream side. The gas supply pipe 271 is connected to the transfer chamber 217. An inert gas is supplied when the transfer chamber 217 is under an inert gas atmosphere or when the transfer chamber 217 is in a vacuum state.

The third gas source 272 is an inert gas source. A third gas supply system 270 mainly includes the gas supply pipe 271, MFC 273, and valve 274. The third gas source 272 may also be included in the third gas supply system 270. The third gas supply system 270 is also referred to as a transfer chamber supply system.

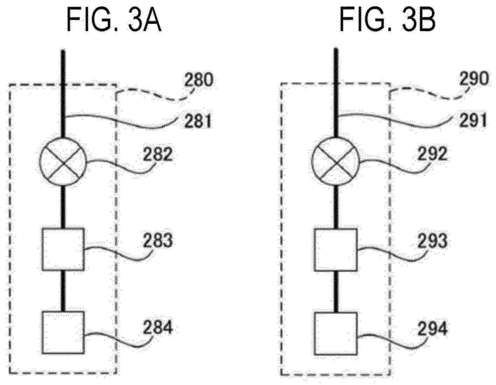

Next, an exhaust system will be described with reference to FIGS. 3A and 3B. An exhaust system 280 configured to exhaust the atmosphere of the reaction tube 210 includes an exhaust pipe 281 that is in fluid communication with the reaction tube 210, and is connected to the housing 241 via an exhaust pipe connector 242.

As illustrated in FIG. 3A, the exhaust pipe 281 is connected to a vacuum pump 284 serving as a vacuum exhauster, via a valve 282 and an auto pressure controller (APC) valve 283 serving as a pressure regulator (pressure regulation part), and is configured to be capable of performing a vacuum exhaust such that an internal pressure of the reaction tube 210 reaches a predetermined pressure (state of vacuum). The exhaust pipe 281, valve 282, and APC valve 283 are collectively referred to as the exhaust system 280. The exhaust system 280 is also referred to as a process chamber exhaust system. In addition, the vacuum pump 284 may also be included in the exhaust system 280. An exhaust system 290 configured to exhaust the atmosphere of the transfer chamber 217 is connected to the transfer chamber 217, and includes an exhaust pipe 291 that is in fluid communication with the interior of the transfer chamber 217.

As illustrated in FIG. 3B, the exhaust pipe 291 is connected to a vacuum pump 294 via a valve 292 and an APC valve 293, and is configured to be capable of performing a vacuum exhaust such that an internal pressure of the transfer chamber 217 reaches a predetermined pressure. The exhaust pipe 291, valve 292, and APC valve 293 are collectively referred to as the exhaust system 290. The exhaust system 290 is also referred to as a transfer chamber exhaust system. In addition, the vacuum pump 294 may also be included in the exhaust system 290.

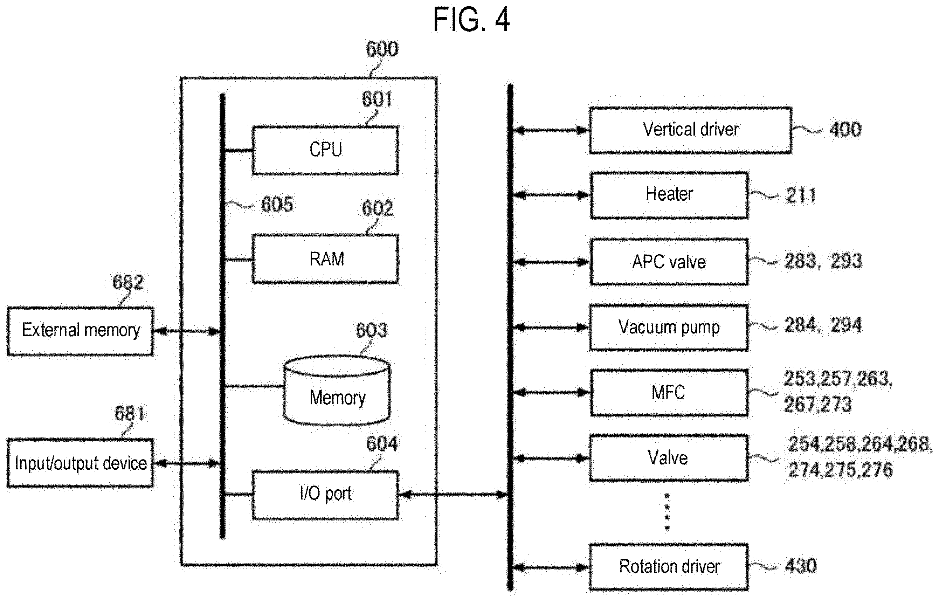

Next, a controller, which is a control part (control means or unit), will be described with reference to FIG. 4. The substrate processing apparatus 10 includes a controller 600 configured to control an operation of each component of the substrate processing apparatus 10.

The controller 600 is schematically illustrated in FIG. 4. The controller 600 is constituted as a computer including a central processing unit (CPU) 601, a random access memory (RAM) 602, a memory 603 as a memory part, and an I/O port 604. The RAM 602, memory 603, and I/O port 604 are configured to be capable of exchanging data with the CPU 601 via an internal bus 605.

The memory 603 is constituted as, for example, a flash memory, a hard disk drive (HDD), and the like. The memory 603 stores, in a readable manner, a control program that controls the operation of the substrate processing apparatus 10, a process recipe including procedures, conditions and others of a substrate process, and the like.

In addition, the process recipe functions as a program configured to be capable of causing the controller 600 to execute procedures of a substrate-processing step as described later to obtain a predetermined result. Hereinafter, the process recipe, control program, and the like are collectively referred to simply as "program." In addition, when the term "program" is used herein, it may include the process recipe, or may include the control program, or may include both of them. Further, the RAM 602 is constituted as a memory area (work area) in which programs, data, and others read by the CPU 601 are temporarily held.

The I/O port 604 is connected to the above-described vertical driver 400, heater 211, APC valves 283 and 293, vacuum pumps 284 and 294, and MFCs 253, 257, 263, 267 and 273, valves 254, 258, 264, 268, 274, 275 and 276, rotation driver 430, and others.

The CPU 601 is configured to read and execute the control program from the memory 603 and to read the process recipe from the memory 603 in response to the input of an operation command from an input/output device 681, etc. Then, the CPU 601 is configured to control, according to contents of the read process recipe, an operation of raising or lowering the substrate support 300 by the vertical driver 400, a heating operation by the heater 211, an opening/closing operation of the APC valves 283 and 293, an operation of starting or stopping the vacuum pumps 284 and 294, a flow rate regulation operation of various gases by the MFCs 253, 257, 263, 267 and 273, an opening/closing operation of the valves 254, 258, 264, 268, 274, 275 and 276, an operation of rotating the substrate support 300 and adjusting a rotational speed thereof of by using the rotation driver 430, and the like.

The controller 600 according to the embodiments of the present disclosure may be constituted, for example, by installing a program to a computer by using an external memory (e.g., a magnetic disk such as a hard disk, an optical disc such as a DVD, a magneto-optical disc such as a MO, and a semiconductor memory such as a USB memory) 682 storing the above-described program. Further, a configuration of supplying the program to the computer is not limited to supplying the program via an external memory 682. For example, the program may be supplied by using a communication means or unit such as the Internet or a dedicated line without using the external memory 682. In addition, the memory 603 or the external memory 682 is constituted as a computer-readable recording medium storing the program. Hereinafter, these are collectively referred to as a recording medium. In addition, when the term "recording medium" is used herein, it may refer to the memory 603, the external memory 682, or both of them.

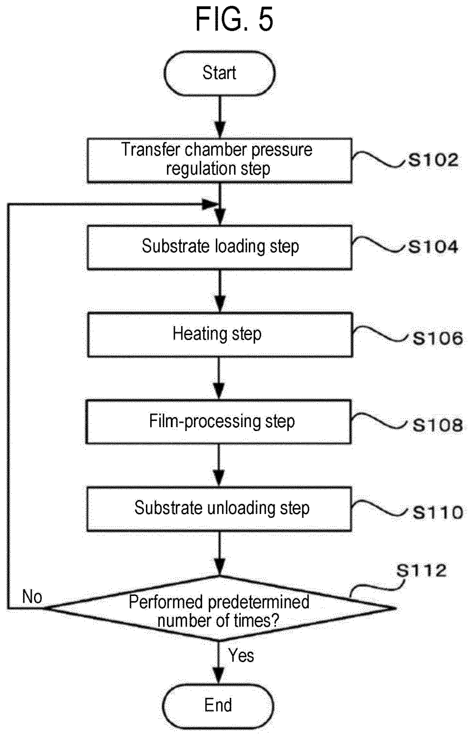

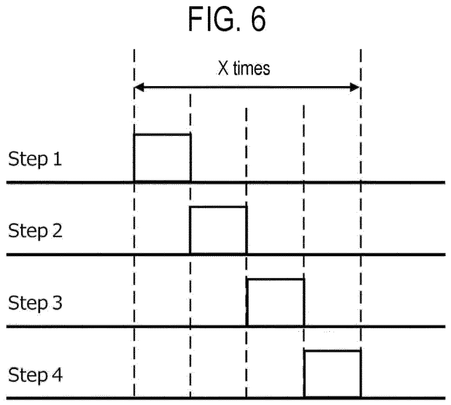

Next, a step of forming a thin film over the substrate S by using the substrate processing apparatus 10 of the above-described configuration will be described as a semiconductor manufacturing step with reference to FIGS. 5 and 6. In addition, in the following description, an operation of each component constituting the substrate processing apparatus 10 is controlled by the controller 600.

Here, a film-forming process of forming a film in a recess such as a trench or hole in the substrate S by using a first gas and a second gas will be described. For example, a gas containing a halogen element may be used as the first gas. A hexachlorodisilane (Si₂Cl₆, abbreviation: HCDS) gas may be used.

The term "substrate" as used herein may refer to a substrate itself or a stack of a substrate and a predetermined layer or film formed over a surface of the substrate. The term "surface of the substrate" as used herein may refer to a surface of a substrate itself or a surface of a predetermined layer or film formed over a substrate. When it is stated herein "forming a predetermined layer over a substrate," it may refer to "directly forming a predetermined layer on a surface of a substrate itself" or "forming a predetermined layer on a layer or the like formed on a substrate." When the term "wafer" is used herein, it is also synonymous with the term "substrate. "

### (S102)

A transfer chamber pressure regulation step S102 will be described. Here, an internal pressure of the transfer chamber 217 is set to a pressure which is at the same level as that of a vacuum transfer chamber (not illustrated) adjacent to the transfer chamber 217. Specifically, the exhaust system 290 is activated to exhaust the atmosphere of the transfer chamber 217 such that the atmosphere of the transfer chamber 217 reaches a vacuum level.

### (S104)

Next, a substrate loading step S104 will be described. When the atmosphere of the transfer chamber 217 reaches the vacuum level, the transfer of the substrate S begins. When the substrate S arrives at the vacuum transfer chamber, a gate valve is opened, and the vacuum transfer robot loads the substrate S into the transfer chamber 217.

At this time, the substrate support 300 is on standby inside the transfer chamber 217, and the substrate S is transferred to the substrate support 300. Once a predetermined number of substrates S are transferred to the substrate support 300, the vacuum transfer robot is retracted, and the substrate support 300 is raised by the vertical driver 400 to move the substrates S into the reaction tube 210. At this time, the surface of the substrate S is positioned to align with the heights of the partition plates 226 and 232.

### (S106)

Next, a heating step S106 will be described. Once the substrate S is loaded into the reaction tube 210, the internal pressure of the reaction tube 210 is controlled to be a predetermined pressure, and a surface temperature of the substrate S is controlled to be a predetermined temperature. When using, for example, a HCDS gas as the first gas, the temperature of the heater 211 may be controlled such that the temperature of the substrate S becomes, for example, 100 to 1500 degrees C, specifically 200 to 1000 degrees C, and more specifically 400 to 800 degrees C. Further, the internal pressure of the reaction tube 210 may be, for example, 0.01 to 1 kPa.

### (S108)

Next, a film-processing step S108 will be described. In the film-processing step S108, a predetermined film is formed over the substrate S including a recess in a surface thereof according to the process recipe by performing, one or more times, a process including a first gas supply step of flash-supplying the first gas to the substrate S and a second gas supply step of flash-supplying the second gas to the substrate S, as described later.

### <First Gas Supply Step, Step S1>

In this step, the first gas is flash-supplied to the process chamber 201 in which the substrate S is placed. Here, the term "flash supply" refers to supplying a large flow rate of gas into the reaction tube 210 within a short time.

Specifically, in this step, the first gas is stored in advance in the tank 259 provided at the gas supply pipe 251. When using, for example, a HCDS gas as the first gas, an internal pressure of the tank 259 at this time is set, for example, to a range of 0.01 to 100 kPa, and specifically to a range of 0.1 to 1.0 kPa.

Then, when supplying the first gas, the valve 254 provided between the tank 259 and the nozzle 223 at a downstream side of the tank 259 is opened, such that the first gas is supplied into the gas supply pipe 251 from the tank 259 in which the first gas is stored in advance. At this time, the internal pressure (total pressure) of the process chamber 201 is set, for example, to a range of 0.01 to 100 kPa, and specifically to a range of 0.1 to 1.0 kPa. Then, once a predetermined time elapses after beginning the supply of the first gas, the valve 254 is closed to stop the supply of the first gas into the gas supply pipe 251. When using, for example, a HCDS gas as the first gas, the valve 254 is closed to stop the supply of the first gas into the gas supply pipe 251 after a time, for example, within a range of 0.01 to 10 seconds elapses.

A large quantity of the first gas is supplied from the gas supply structure 212 into the reaction tube 210 via the upstream gas guide 214 within a short time. Thereafter, the first gas is discharged via a space over the substrate S, the downstream gas guide 215, the gas exhaust structure 213, and the exhaust pipe 281. At this time, the valve 282 and the APC valve 283 are in the open state. Here, the valve 275 may be in the open state or the closed state while supplying the first gas into the process chamber 201.

At this time, the first gas may be supplied into the process chamber 201 such that a decomposition rate of the first gas is reduced inside the process chamber 201.

Further, when forming a film in the recess (or groove, trench, hole) formed in the substrate S, as a reactivity of the gas increases, an adsorption to an opening side of the recess becomes easier and an adsorption to a deep side of the recess becomes more difficult. Therefore, when using, as the first gas, a gas that generates a highly reactive substance by decomposition (e.g., HCDS gas) to form a film in the recess, a residence time τ of the first gas may be shortened and/or a flow velocity v of the first gas may be increased to lower a decomposition rate X, thereby enhancing a step coverage. In addition, by controlling the residence time τ of the first gas and/or the flow velocity v of the first gas to achieve 0% of the decomposition rate X for the first gas, it is possible to enhance the step coverage. A method of shortening the residence time τ of the first gas and increasing the flow velocity v of the first gas is to supply the first gas while increasing an opening state of the APC valve 283 by using the tank 259.

When using, for example, a HCDS gas as the first gas, the flow velocity of the first gas may be set to, for example, 10 m/sec or more to lower the decomposition rate X to a range of 0 to 25%, thus enhancing the step coverage. Further, by setting the flow velocity of the first gas to, for example, 15 m/sec or more, the decomposition rate may be further lowered to a range of 0 to 15%, thus further enhancing the step coverage. Furthermore, by controlling the flow velocity of the first gas to 20.0 m/sec or more, 0% of the decomposition rate may be achieved, in other words, the first gas may not be decomposed, thus further enhancing the step coverage.

In other words, in this step, the decomposition rate X of the first gas supplied to the substrate S may be changed by flash-supplying the first gas. Further, by flash-supplying the first gas in this step, the flow velocity of the first gas may be controlled, which in turn controls the residence time of the first gas in the process chamber 201, thereby enabling the decomposition rate X of the first gas to be controlled.

Further, in this step, by flash-supplying the first gas, a supply amount of the first gas may be increased at the beginning of the supply of the first gas. When using, for example, a HCDS gas as the first gas, a supply amount of the first gas per unit time for each substrate S may be set, for example, to a range of 0.001 to 15 slm, specifically to a range of 0.05 to 10 slm, and more specifically to a range of 0.010 to 5 slm. When the supply amount is set to be smaller than 0.001 slm, a partial pressure of the first gas may be decreased inside the process chamber 201, thus decreasing a film formation rate. When the supply amount is set to be greater than 15 slm, the partial pressure of the first gas may be increased inside the process chamber 201, leading to an excessive decomposition of the first gas. When the supply amount is set to a range of 0.001 to 15 slm, it is possible to change the flow velocity of the first gas by controlling a flow rate of the first gas while preventing a decrease in the film formation rate and the excessive decomposition of the first gas. Further, when the supply amount is set to a range of 0.05 to 10 slm, it is possible to change the flow velocity of the first by controlling the flow rate of the first gas while further preventing a decrease in the film formation rate and the excessive decomposition of the first gas. When the supply amount is set to a range of 0.010 to 5 slm, it is possible to change the flow velocity of the first gas by controlling the flow rate of the first gas while sufficiently preventing a decrease in the film formation rate and the excessive decomposition of the first gas.

Further, by flash-supplying the first gas, the first gas which is pressurized (i.e., whose pressure is increased) inside the tank 259 may be supplied into the process chamber 201. Thus, it is possible to increase the flow velocity of the first gas at the beginning of the supply.

Further, as described above, in this step, the valve 282 and the APC valve 283 are in the open state, and while supplying the first gas into the process chamber 201, the interior of the reaction tube 210 is exhausted by the vacuum pump 284. This lowers the internal pressure of the process chamber 201 and increases the flow velocity of the first gas, thereby shortening the residence time τ of the first gas inside the process chamber 201.

Further, while supplying the first gas into the process chamber 201, the valve 258 may be opened and an inert gas may be supplied into the gas supply pipe 251 via the gas supply pipe 255. The inert gas such as nitrogen (N₂), helium (He), or argon (Ar) may be used. One or more of these gases may be used as the inert gas. This is also applied similarly to each step as described later.

Further, before this step and before beginning the supply of the first gas into the process chamber 201, the APC valve 283 may be regulated to exhaust the interior of the reaction tube 210 by the vacuum pump 284. This may increase the flow velocity of the first gas, specifically the flow velocity at the beginning of the supply, thus shortening the residence time τ of the first gas inside the process chamber 201.

Further, the internal temperature of the process chamber 201 in this step may be set to be higher than the decomposition temperature of the first gas. This may increase the reactivity of the first gas to improve the film deposition rate, and may shorten the residence time of the first gas inside the process chamber 201 to prevent an increase in the decomposition rate of the first gas.

This step may be performed such that at least some of adsorption sites on the surface of the substrate S are converted into first element sites where a first element-containing substance, which is a substance containing the first element contained in the first gas, is chemically adsorbed.

In the above-described embodiments of the present disclosure, for example, silicon (Si) and germanium (Ge), which are group 14 elements, and aluminum (Al), gallium (Ga), and indium (In), which are group 13 elements, may be used as the first element. Further, for example, a transition metal element may be used as the first element. For example, titanium (Ti), zirconium (Zr), and Hf (hafnium), which are group 4 elements, niobium (Nb) and tantalum (Ta), which are group 5 elements, molybdenum (Mo) and tungsten (W), which are group 6 elements, manganese (Mn), which is a group 7 element, ruthenium (Ru), which is a group 8 element, cobalt (Co), which is a group 9 element, and nickel (Ni), which is a group 10 element, and the like may be used as the first element.

For example, a Si-containing gas that contains Si as the first element may be used as the first gas. An example of the Si-containing gas may include a Si- and chlorine (Cl)-containing gas. For example, a precursor gas containing Si-Si bonds such as a HCDS gas may be used as the Si- and Cl-containing gas. Further, for example, 1,1,2,2-tetrachloro-1,2-dimethyldisilane ((CH₃)₂Si₂Cl₄, abbreviation: TCDMDS) or 1,2-dichloro-1,1,2,2-tetramethyldisilane ((CH₃)₄Si₂Cl₂, abbreviation: DCTMDS) may be used as the Si- and Cl-containing gas. TCDMDS contains Si-Si bonds and further contains chloro groups and alkylene groups. Further, DCTMDS contains Si-Si bonds and further contains chloro groups and alkylene groups. One or more of these may be used as the first gas.

When using, for example, a HCDS gas as the first gas, the HCDS gas is decomposed to cut bonding hands in the Si-Si bonds, resulting in generation of SiCl₄ and SiCl₂ which is higher in reactivity than the HCDS gas. In other words, the HCDS gas is decomposed as follows.

HCDS (Si₂Cl₆)→SiCl₄+SiCl₂

Since SiCl₄ and SiCl₂ are higher in reactivity than HCDS, the decomposition rate of HCDS is high, such that the reaction progresses as the decomposition of HCDS progresses. Then, when using, for example, an ammonia (NH₃) gas as the second gas as described later, SiCl₂ and SiCl₄ react respectively with NH groups as described later to form a SiN layer. At this time, reaction by-products such as hydrogen chloride (HCl) are generated.

At least some of the adsorption sites on the surface of the substrate S are converted into Si sites where a Si-containing substance, which is a substance containing Si, is chemically adsorbed, but reaction by-products such as HCl are adsorbed to the adsorption sites on the substrate S, preventing the adsorption of the Si-containing substance. In this step, by flash-supplying the first gas, a large quantity of the first gas is supplied to the substrate S within a short time from the beginning of the supply, which reduces adsorption sites on the substrate S for reaction by-products such as HCl, thus increasing the adsorption of the Si-containing substance. Thus, it is possible to increase a film formation rate and a step coverage performance.

### <Purge, Step S2>

In this step, a purge gas is supplied to the process chamber 201 in which the substrate S is placed. In other words, after the flash-supply of the first gas in step S1, the Si-containing substance that is not adsorbed on the adsorption sites and reaction by-products that are re-adsorbed on the surface of the substrate S are desorbed and removed from the interior of the reaction tube 210.

Specifically, with the valve 254 open, the valve 275 is closed and the valves 258, 268 and 264 are opened to supply an inert gas serving as the purge gas into the gas supply pipes 251 and 261 via the gas supply pipes 255 and 265. At the same time, the valve 282 and the APC valve 283 on the exhaust pipe 281 remain open, such that the interior of the reaction tube 210 is exhausted by the vacuum pump 284.

### <Second Gas Supply Step, Step S3>

Next, the second gas that reacts with the first gas is supplied to the process chamber 201 in which the substrate S is arranged. Specifically, in this step, the second gas is stored in advance in the tank 269 provided at the gas supply pipe 261. Then, when supplying the second gas, the valve 264 provided at the downstream side of the tank 269 between the tank 269 and the nozzle 224 is opened, such that the second gas is supplied into the gas supply pipe 261 from the tank 269 in which the second gas is stored in advance. Then, once a predetermined time elapses after beginning the supply of the second gas, the valve 264 is closed to stop the supply of the second gas into the gas supply pipe 261.

A large quantity of the second gas is supplied from the gas supply structure 212 into the reaction tube 210 via the upstream gas guide 214 within a short time, and is then discharged via a space above the substrate S, the downstream gas guide 215, the gas exhaust structure 213, and the exhaust pipe 281. At this time, the valve 282 is in the open state. The APC valve 283 is regulated to be in a predetermined opening state. Here, the valve 276 may be in the open state or the closed state while supplying the second gas into the process chamber 201. The valve 276 may be in the open state. Further, the valve 268 may be opened to cause an inert gas flow through the gas supply pipe 261 via the gas supply pipe 265. Further, the valves 258 and 254 may be opened to cause an inert gas to flow through the gas supply pipe 251 to prevent the second gas from entering the gas supply pipe 251. At this time, a large quantity of the second gas is supplied to the substrate S at once in the horizontal direction from a lateral side of the substrate S via the gas supply structure 212 which is in fluid communication with the interior of the reaction tube 210.

In this step, the second gas is flash-supplied. By supplying the second gas whose pressure is increased inside the tank 269 into the process chamber 201, it is possible to achieve a uniform in-plane supply of the second gas to the surface of the substrate S. Specifically, when the substrate S includes a recess to be a semiconductor device structure, it is possible to supply the second gas even to a bottom of the recess.

Further, in this step, the APC valve 283 is regulated to be in a predetermined opening state, and the interior of the reaction tube 210 is exhausted by the vacuum pump 284 while the second gas is supplied into the process chamber 201. This allows the interior of the process chamber 201 to reach a predetermined pressure. Further, the interior of the process chamber 201 may be maintained at a predetermined pressure.

Specifically, in this step, the second gas is stored in advance in the tank 269 provided at the gas supply pipe 261. When using, for example, a NH₃ gas as the second gas, the internal pressure of the tank 269 at this time is set, for example, to a range of 0.01 to 100 kPa, and specifically to a range of 0.1 to 50 kPa.

Then, when supplying the second gas, the valve 264 (also referred to as "downstream valve") provided at the downstream side of the tank 269 is opened to supply the second gas from the tank 269 into the gas supply pipe 261. At this time, the internal pressure (voltage) of the process chamber 201 is set, for example, to a range of 0.1 to 100 kPa, specifically to a range of 300 Pa to 5 kPa, more specifically to a range of 300 Pa to 3 kPa, and even more specifically to a range of 2 to 2.6 kPa. Then, once a predetermined time elapses after beginning the supply of the second gas, the valve 264 is closed to stop the supply of the second gas into the gas supply pipe 261. Further, this step may be performed by opening the valve 276 (also referred to as "upstream valve") provided at the upstream side of the tank 269. In this operation, a time for supplying the second gas is approximately within a range of 0.1 to 5 seconds, specifically within a range of 2 to 5 seconds, and more specifically within a range of 2 to 4 seconds.

A large quantity of the second gas is supplied from the gas supply structure 212 into the reaction tube 210 via the upstream gas guide 214 within a short time. Thereafter, the gas is discharged via the space on the substrate S, the downstream gas guide 215, the gas exhaust structure 213, and the exhaust pipe 281.

In addition, an internal temperature of the process chamber 201 at this time may be set to be higher than the decomposition temperature of the second gas. Further, as in step S1 described above, the decomposition rate X of the second gas in this step may be controlled by setting the residence time τ of the second gas based on a predetermined relationship between the decomposition rate X of the second gas inside the process chamber 201 and the residence time τ of the second gas inside the process chamber 201.

For example, a gas containing a second element different from the first gas may be used as the second gas. The second element is, for example, N, oxygen (O), or carbon (C). For example, a hydrogen (H)- and N-containing gas may be used as the second gas. Examples of the H- and N-containing gas may include a hydrogen nitride-based gas containing N-H bonds such as ammonia (NH₃) gas, diazen (N₂H₂) gas, hydrazine (N₂H₄) gas, and N₃H₈ gas. One or more of these may be used as the second gas.

When using, as the second gas, the hydrogen nitride-based gas containing N-H bonds such as NH₃ or N₂H₄ in which multiple hydrogens bond to nitrogen, the following successive reaction may occur on the surface of the substrate S. In the model described below, x, y, and z are integers, there is a relationship of x>y>z, and a reaction may occur in which H is desorbed from a N-H bonded molecule (ligand) until z becomes 1. NHₓ, NH_{y}, H, etc. (also referred to as "desorbed substance" in the present disclosure) may be desorbed until z becomes 1. This desorption may occur in this step S3 and in other steps.

### Successive reaction model: NHₓ→7NH_{y}→7NH_{z}

In the film-forming process where such a successive reaction occurs, it may be challenging to improve uniformity of characteristics of a film formed over the substrate S. Specifically, when a recess is formed in the substrate S, a film formed at the top of the recess and a film formed on the bottom of the recess may be different in film characteristics from each other. Here, the film characteristics include a film thickness, a nitrogen deficiency, a refractive index, and the like.

The above-described desorbed substance may be generated in this step S3 and in other steps. For example, in a case where the desorbed substance is generated in step S1 that is performed after step S3, the desorbed substance and the first gas may react each other (gas phase reaction). In a case where such a gas phase reaction occurs, unintended film may be formed, making it impossible to improve uniformity of the film characteristics of the substrate S. For example, it becomes challenging to enhance a step coverage (S/C) of the film formed in the recess.

To address such challenges, in step S3 of the present disclosure, the second gas may be flash-supplied under the above-described condition to shorten a time until the above-described successive reaction converges, which may resolve the above-described challenges caused by the successive reaction. Specifically, for the substrate S in which the recess is formed, it is possible to allow S/C for the film formed in the recess to approach 100%. Further, when the film formed in the recess is a nitrogen-containing film, it is possible to form a film with a nitrogen deficiency of 2.5×10¹⁸ atoms/cm³ or more from the top to the bottom of the recess.

Further, the above-described second gas supply condition (pressure, time, and the like) may be regulated according to an aspect ratio of the recess formed in the substrate S.

Further, in the film-forming process with the above-described successive reaction model, a supply time of the second gas may be longer than a supply time of the first gas. Thus, it is possible to uniformly supply the second gas throughout the surface of the substrate S. Specifically, a sufficient quantity of the second gas may be supplied to the bottom of the recess.

Further, in the film-forming process with the above-described successive reaction model, an opening state of the APC valve 283 when supplying the second gas may be set smaller than an opening state of the APC valve 283 when supplying the first gas. Thus, it is possible to uniformly supply the second gas throughout the surface of the substrate S. Specifically, a sufficient quantity of the second gas may be supplied to the bottom of the recess.

Further, in the film-forming process with the above-described successive reaction model, the internal pressure of the process chamber 201 when supplying the second gas may be set higher than the internal pressure of the process chamber 201 when supplying the first gas. Thus, it is possible to uniformly supply the second gas throughout the surface of the substrate S. Specifically, a sufficient quantity of the second gas may be supplied to the bottom of the recess.

Further, in the film-forming process with the above-described successive reaction model, the supply amount of the second gas may be greater than the supply amount of the first gas. Thus, it is possible to uniformly supply the second gas throughout the surface of the substrate S. Specifically, a sufficient quantity of the second gas may be supplied to the bottom of the recess. A supply amount of each gas refers to one or more selected from the group of pressure, time, tank capacity, and internal pressure of the tank, and the like.

Further, in the film-forming process with the above-described successive reaction model, it is desired to shorten the time for the successive reaction to converge. Further, when the recess is formed in the substrate S, the time for convergence of the successive reaction may be aligned between the top (opening side) and the bottom (deep side) of the recess. A method to achieve the above may include flash-supplying the second gas under the above-described condition.

### <Purge, Step S4>

In this step, a purge gas is supplied to the process chamber 201 in which the substrate S is place by the same process procedure as in step S2. In other words, after the flash-supply of the second gas in step S3, the second gas that is not adsorbed on the adsorption sites and reaction by-products that are generated by the reaction with the second gas and re-adsorbed on the surface of the substrate S are desorbed and removed from the interior of the reaction tube 210.

Specifically, with the valve 264 open, the valve 276 is closed and the valves 268, 258 and 254 are opened to supply an inert gas serving as the purge gas into the gas supply pipes 251 and 261 via the gas supply pipes 255 and 265. At the same time, the valve 282 and the APC valve 283 provided at the exhaust pipe 281 remain open, and the interior of the reaction tube 210 is vacuum-exhausted by the vacuum pump 284. This may prevent a reaction between the first gas and the second gas existing in a gaseous state inside the reaction tube 210.

### (Performed Predetermined Number of Times)

A film with a predetermined thickness is formed over the substrate S including the recess by performing a cycle a predetermined number of times (n times, n is an integer of 1 or more), the cycle including performing the above-described first gas supply step and second gas supply step sequentially and non-simultaneously. When using, for example, a HCDS gas as the first gas and the H- and N-containing gas as the second gas, a SiN film is formed. This allows formation of a film over the substrate S including the recess with an enhanced step coverage performance and increased film formation rate of the film

### (S110)

Next, a substrate unloading step S110 will be described. In S110, the processed substrate S is unloaded out of the transfer chamber 217 in the reverse procedure of the above-described substrate loading step S104.

### (S1 12)

Next, determination S112 will be described. Here, it is determined whether or not the substrate was processed a predetermined number of times. In response to determining that the substrate was not processed the predetermined number of times, the process returns to the substrate loading step S104 and the next substrate S is processed. In response to determining that the substrate was processed the predetermined number of times, the process is terminated.

In addition, in the embodiments described above, the gas flow is formed in the horizontal direction, but the gas flow may be diffused in a vertical direction as long as a main gas flow is formed in the overall horizontal direction and the gas flow does not affect the uniform processing of a plurality of substrates.

Further, in the embodiments described above, expressions such as the same degree, equal, equivalent, and the like may include substantially the same.

### (Other Embodiments)

The embodiments of the present disclosure are specifically described above, but the present disclosure is not limited thereto, and may be modified in various ways without departing from the spirit thereof.

In the above-described embodiments, the cases in which the tank 259 is installed in the above-described first gas supply system 250 are described, but the present disclosure is not limited thereto. In other words, in the first gas supply system 250, the tank 259 may not be provided and the first gas may be supplied by a method other than flash-supply. In this case as well, the same effects as in the above-described embodiments are obtained.

Similarly, the cases in which the tank 269 is provided at the above-described second gas supply system 260 are described above, but the present disclosure is not limited thereto. In other words, in the second gas supply system 260, the tank 269 may not be provided and the second gas may be supplied by a method other than flash-supply. In this case as well, the same effects as in the above-described embodiments are obtained.

Further, in the above-described embodiments, the cases where the film is formed over the substrate S by using the first gas and the second gas in the film-forming process performed by the substrate processing apparatus are described by way of example, but the present disclosure is not limited thereto. In other words, as the process gases used in the film-forming process, other types of gases may be used to form other types of thin films. Furthermore, the present disclosure may be applied even when three or more types of process gases are used.

Further, in the above-described embodiments, the film-forming process are described by way of example as a process performed by the substrate processing apparatus, but the present disclosure is not limited thereto. In other words, the present disclosure may be applied to film-forming processes other than the film-forming process mentioned in the above-described embodiments.

Further, in the above-described embodiments, the cases where the film is formed by using a batch-type substrate processing apparatus configured to process a plurality of substrates at a time are described by way of example. The present disclosure is not limited to the above-described embodiments, and for example, may be suitably applied to a case where a film is formed by using a single-wafer-type substrate processing apparatus configured to process one or several substrates at a time. Further, in the above-described embodiments, the cases where a film is formed by using a substrate processing apparatus including a hot-wall-type process furnace are described by way of example. The present disclosure is not limited to the above-described embodiments and may be suitably applied to the case where a film is used by using a substrate processing apparatus including a cold-wall-type process furnace as well.

Even when using such a substrate processing apparatus, it is possible to perform each process by using the same process procedures and process conditions as in the above-described embodiments and modifications and to achieve the same effects as in the above-described embodiments and modifications.

The above-described embodiments and modifications may be combined and used as appropriate. Process procedures and process conditions in such a case may be the same as the process procedures and process conditions in the above-described embodiments and modifications, for example.

According to the present disclosure in some embodiments, it is possible to improve uniformity of a film formed over a substrate.

While certain embodiments are described above, these embodiments are presented by way of example, and are not intended to limit the scope of the disclosures. Indeed, the embodiments described herein may be embodied in a variety of other forms. Furthermore, various omissions, substitutions and changes in the form of the embodiments described herein may be made without departing from the spirit of the disclosures. The accompanying claims and their equivalents are intended to cover such forms or modifications as would fall within the scope and spirit of the disclosures.

## Claims

1. A method of processing a substrate, comprising:
(a) supplying a first process gas to the substrate; and
(b) supplying a second process gas from at least one second reservoir to the substrate,
wherein (b) is performed in a manner so as to shorten a time until a successive reaction of the second process gas on the substrate converges.

2. The method of Claim 1, wherein in (b), a pressure in an area where the substrate is present is set to a range of 300 Pa to 3000 Pa, and a supply time of the second process gas is set to a range of 2 seconds to 5 seconds.

3. The method of Claim 1, wherein in (b), a pressure in an area where the substrate is present is set to a range of 2000 Pa to 2600 Pa, and a supply time of the second process gas is set to a range of 2 seconds to 4 seconds.

4. The method of Claim 1, wherein in (a), the first process gas is supplied from a first reservoir.

5. The method of Claim 1, wherein the at least one second reservoir includes a plurality of second reservoirs, and
wherein in (b), the second process gas is supplied from the plurality of second reservoirs.

6. The method of Claim 1, wherein (b) is performed while an upstream valve and a downstream valve of the at least one second reservoir are open.

7. The method of Claim 1, wherein the first process gas and the second process gas are supplied from a gas supplier protruding in a horizontal direction, at a lateral side of a process container configured to accommodate the substrate, and are discharged via an exhauster which faces the gas supplier.

8. The method of Claim 2, wherein the substrate includes a recess, and
wherein the method further comprises (c) changing the pressure in (b) based on an aspect ratio of the recess.

9. The method of Claim 1, wherein in (b), the second process gas is supplied from the at least one second reservoir to the substrate for a time longer than a supply time of the first process gas.

10. The method of Claim 1, wherein a pressure in an area where the substrate is present is set to be higher when performing (b) than when performing (a).

11. The method of Claim 1, wherein in (b), a supply amount of the second process gas is greater than a supply amount of the first process gas.

12. The method of Claim 1, wherein the substrate includes a recess, and
wherein in (b), the second process gas is supplied such that the successive reaction occurring at a top of the recess and the successive reaction occurring at a bottom of the recess are completed simultaneously.

13. A method of manufacturing a semiconductor device, comprising the method of Claim 1.

14. A program that causes, by a computer, a substrate processing apparatus to perform a process comprising:
(a) supplying a first process gas to a substrate;
(b) supplying a second process gas from a second reservoir to the substrate; and
(c) shortening a time until a successive reaction of the second process gas on the substrate converges.

15. A substrate processing apparatus comprising:
a first gas supply system configured to supply a first process gas to a substrate;
a second gas supply system including a second reservoir and configured to supply a second process gas to the substrate; and
a controller configured to be capable of controlling the first gas supply system and the second gas supply system to perform a process comprising:
(a) supplying the first process gas to the substrate;
(b) supplying the second process gas from the second reservoir to the substrate; and
(c) shortening a time until a successive reaction of the second process gas on the substrate converges.
